# DEMANDE DE BREVET EUROPEEN

(11) **EP 2 391 197 A1**
(43) Date de publication de la demande: **30.11.2011**
(21) Numéro de dépôt: 11167727.4
(22) Date de dépôt: 26.05.2011
(51) Int. Cl.: H05K 7/20

(54) **Optimisation de la performance energetique d'un centre comportant des equipements energivores.**

(30) Priorité: 31.05.2010 FR 1054190
(71) Demandeur: Atrium Data, 75008 Paris (FR)
(72) Inventeur: Dernis, Michel, 92200 NEUILLY SUR SEINE (FR); Duflos, Thierry, 92300 LEVALLOIS-PERRET (FR)
(74) Mandataire: Derambure, Christian

(57) **Abrégé**

Dans le procédé d'optimisation de la performance énergétique d'un centre de traitement de données ayant des moyens d'infrastructure (4), des équipements fonctionnels (2), des moyens de conditionnement d'air (5), alimentés par des moyens d'alimentation électrique (3), on dispose de moyens de mesure (6) de paramètres sur l'air, de paramètres sur le centre, de moyens de transmission, de stockage et de traitement de données (7, 8, 9, 10, 11, 12, 13, 14), d'une pluralité de compteurs électriques (15a, 15b...), on définit une pluralité de groupes homogènes d'alimentation électrique et on organise les moyens d'alimentation électrique (3) pour disposer d'une pluralité d'alimentations (3a, 3b...) de la pluralité de groupes homogènes, on associe à chaque alimentation électrique (3a, 3b...) un compteur électrique (15a, 15b...), on mesure la consommation électrique de la pluralité d'alimentations électriques (3a, 3b...) et les paramètres sur l'air, on transmet les mesures à des moyens de stockage (11) et on traite les mesures et les paramètres stockés selon des protocoles permettant de calculer des indices et/ou indicateurs et on les compare avec des indices et/ou indicateurs de référence.

## Description

L'invention vise à optimiser la performance énergétique d'un centre comportant des équipements énergivores, tels que les équipements électroniques, informatiques ou de télécommunications ainsi que d'autres équipements énergivores tels que des équipements de conditionnement d'air, d'éclairage... d'un centre de traitement de données (connu couramment sous le nom de data centre ou data center). Toutefois, l'invention s'applique à tout autre type de centre comportant des équipements énergivores. En outre, l'invention vise également à comparer les performances énergétiques de plusieurs centres.

Plus particulièrement, l'invention a pour objet, en premier lieu, un procédé d'optimisation de la performance énergétique d'un tel centre de traitement de données, comportant au moins une salle, et des moyens d'alimentation électrique, des moyens d'infrastructure énergivores tels que des moyens d'éclairage, associés à la au moins une salle et alimentés par les moyens d'alimentation électrique, des équipements fonctionnels énergivores tels que des équipements électroniques, informatiques ou de télécommunications installés dans la au moins une salle et alimentés par les moyens d'alimentation électrique, et des moyens de conditionnement d'air associés aux équipements fonctionnels énergivores, ceux de ces moyens de conditionnement d'air énergivores étant alimentés par les moyens d'alimentation électrique. Elle a pour objet, en second lieu, une architecture d'un dispositif d'optimisation pour la mise en oeuvre du procédé.

Les moyens de conditionnement d'air aptes à procurer aux faces frontales des équipements fonctionnels de l'air filtré dont le débit, la température T₂ - par exemple de l'ordre de 21 °C - et le degré hygrométrique sont maintenus ou compris dans les plages de débits, de températures et de degrés hygrométriques adaptées au fonctionnement optimal des équipements fonctionnels.

L'architecture de tels centres de traitement de données, plus spécialement celle des équipements fonctionnels énergivores et des moyens de conditionnement d'air, peut faire l'objet de différentes réalisations, en fonction notamment des contraintes de place, de capacité ou de puissance...

L'un des problèmes cruciaux de tels centres de traitement de données est l'importance de la consommation énergétique électrique (d'aucuns estiment que dans les pays les plus développés, les centres de traitement de données consomment plusieurs pour cent de la consommation énergétique totale). Cette consommation est élevée pour nombre de raisons. D'une part, la densité des équipements fonctionnels tend à augmenter et ces équipements sont énergivores en fonctionnement, alors que la demande de puissance de calcul tend à croître. D'autre part, le fonctionnement optimal des équipements fonctionnels suppose qu'ils soient alimentés avec de l'air filtré dont le débit, la température et le degré hygrométrique sont maintenus ou compris dans des plages de débits, de températures et de degrés hygrométriques adaptées. Compte tenu de la chaleur générée par les équipements fonctionnels lorsqu'ils sont en fonctionnement, on a été amené à prévoir des dispositifs de conditionnement d'air de plus en plus puissants, eux-mêmes de plus en plus énergivores. Ainsi, on estime que la part principale de la consommation totale en énergie d'un centre de traitement de données, en dehors de la consommation en énergie des équipements informatiques électroniques et de télécommunications, a pour origine le conditionnement d'air.

Le consortium GRID GREEN a conçu un indicateur de performance énergétique des centres de traitement de données : le PUE (acronyme de Power Usage Effectiveness). Cet indicateur mesure le ratio entre la dépense énergétique totale d'un centre de traitement de données et celle propre à ses équipements électroniques, informatiques ou de télécommunication. Par exemple, un PUE de 2 signifie que le centre de traitement de données pris dans son ensemble consomme deux fois plus d'énergie que les équipements qu'il héberge. Les membres du consortium GRID GREEN ont pour objectif d'atteindre un PUE de 1,6 à la fin de l'année 2009.

Les documents US 2009/0254763, US 2009/0251860, US 7 529 086, US 2009/0210096 posent le problème de la maîtrise de la consommation énergétique des centres de traitement de données.

L'état de la technique comprend également les documents US 2006/0168975, US 2009/0241578 et US 2007/0171613, la réalisation du Yokohama Third Center de la société Hitachi Data Systems Corporation qui permet d'atteindre un PUE de 1,6 en combinant un ensemble de moyens tels que centre de commande intégré, simulateur thermohydraulique optimisant le refroidissement, terrasse jardin créatrice d'ombre dans laquelle est placée le centre de traitement de données...

Le document WO 2010/050932, US 2009/0319650 et US 2005/0138438 posent également le problème de la maintenance et de la gestion d'un centre de traitement de données, soulignant que les outils existant à ce jour sont parcellaires et dans la mesure où ils ne permettent pas une synthèse globale et une gestion du centre de traitement de données optimisant les coûts, et parmi ceux-ci la consommation énergétique.

Cette consommation énergétique est dépendante de l'architecture des centres de traitement de données, notamment celle des équipements fonctionnels énergivores et celle des moyens de conditionnement d'air, dont il a été dit précédemment qu'elle était l'objet de différentes réalisations possibles. Comme il a été également indiqué précédemment, cette consommation énergétique est quantitativement importante.

D'autre part, et en premier lieu, cette consommation énergétique est hétérogène puisqu'elle est concerne, notamment, les moyens d'infrastructure énergivores, les équipements fonctionnels énergivores et les moyens de conditionnement d'air énergivores.

En second lieu, cette consommation énergétique est évolutive dans le temps, puisqu'elle dépend des conditions d'emploi de l'infrastructure et des équipements fonctionnels énergivores et des conditions de l'air impactant le conditionnement de l'air (température, hygrométrie... tant de l'air de la salle informatique que de l'air extérieur à celle-ci).

L'état de la technique comprend également les documents US 2010/07607 et US 2009/319650. Dans l'un et l'autre des documents, il s'agit, après avoir enregistré les paramètres liés à la charge, la nature de la charge de chacun des racks et à l'environnement, de définir des règles de réglage des installations, par rapport à une configuration type.

Au contraire, selon l'invention, lorsque l'on souhaite optimiser la performance énergétique du centre de traitement de données, l'on traite les mesures et les paramètres stockés dans les moyens de stockage selon des protocoles et ainsi l'on calcule des indices et/ou indicateurs quantitatifs et/ou qualitatifs. Puis, l'on compare ces indices et/ou indicateurs avec des indices et/ou indicateurs de référence. Et, en fonction des écarts entre les indices et/ou indicateurs calculés et les indices et/ou indicateurs de référence, l'on adapte la mise en oeuvre ou on règle ou adapte le fonctionnement des moyens d'infrastructure énergivores ainsi que des équipements fonctionnels énergivores et des moyens de conditionnement d'air énergivores. Ainsi, l'on optimise la performance énergétique du centre de traitement de données.

L'invention diffère de deux documents en ce que l'on ne cherche pas à établir des règles qui seront appliquées sur le centre, mais de comprendre les raisons pour lesquelles la performance est moins bonne afin de proposer des modifications de la conception du centre. De ce fait, l'invention ne vise pas à se borner à optimiser les réglages de l'installation, mais vise à définir les voies et moyens permettant d'améliorer l'installation, via un système centralisé qui permet de comparer les différents centres entre eux et donc les différentes conceptions entre elles. Ni l'un ni l'autre des deux documents ne donne cet enseignement.

Il existe donc le besoin d'optimiser la consommation énergétique d'un centre de traitement de données d'une façon globale, méthodique, permanente, sans coût de management excessif, et d'une manière qui soit applicable à des configurations très différentes de centres de traitement de données.

Par conséquent, le problème à la base de l'invention est d'apporter une solution à ce besoin.

A cet effet, selon un premier aspect, l'invention a pour objet un procédé d'optimisation de la performance énergétique d'un centre de traitement de données, dans lequel :
- on dispose d'un centre de traitement de données incluant :
   o au moins une salle, et des moyens d'alimentation électrique,
   o des moyens d'infrastructure énergivores tels que des moyens d'éclairage, associés à la au moins une salle et alimentés par les moyens d'alimentation électrique,
   o des équipements fonctionnels énergivores tels que des équipements électroniques, informatiques ou de télécommunications installés dans la au moins une salle et alimentés par les moyens d'alimentation électrique,
   o des moyens de conditionnement d'air associés aux équipements fonctionnels énergivores, des moyens de conditionnement d'air énergivores étant alimentés par les moyens d'alimentation électrique,
   o des moyens de mesure de paramètres reflétant les conditions de l'air impactant le conditionnement de l'air,
- on dispose d'une pluralité de paramètres sur les caractéristiques du centre de traitement de données et de ses moyens constitutifs,
- on dispose de moyens de transmission de données, de moyens de stockage de données et de moyens de traitement de données,
- on dispose d'une pluralité de compteurs électriques,
- on définit une pluralité de groupes homogènes relatifs à l'alimentation électrique et on organise les moyens d'alimentation électrique de sorte à disposer d'une pluralité d'alimentations électriques séparées de la même pluralité de groupes homogènes relatifs à l'alimentation électrique, et on associe à chaque alimentation électrique un compteur électrique de sorte à pouvoir mesurer la consommation électrique de l'alimentation électrique correspondante,
- puis, on mesure la consommation électrique de la pluralité d'alimentations électriques et on mesure les paramètres reflétant les conditions de l'air impactant le conditionnement de l'air, d'un même temps donné, et on réitère ces mesures pour des temps successifs,
- puis, grâce aux moyens de transmission de données, on transmet les mesures de la consommation électrique de la pluralité d'alimentations électriques et les mesures des paramètres reflétant les conditions de l'air impactant le conditionnement de l'air des temps successifs à des moyens de stockage et on stocke ces mesures dans les moyens de stockage, avec les paramètres sur les caractéristiques du centre de traitement de données et de ses moyens constitutifs associés aux mesures.

Avec ce procédé, lorsque l'on souhaite optimiser la performance énergétique du centre de traitement de données, grâce aux moyens de traitement, on traite les mesures et les paramètres stockés dans les moyens de stockage selon un ou plusieurs protocoles permettant de calculer des indices et/ou indicateurs quantitatifs et/ou qualitatifs et on compare ces indices et/ou indicateurs avec des indices et/ou indicateurs de référence et, en fonction des écarts entre les indices et/ou indicateurs calculés et les indices et/ou indicateurs de référence, on adapte la mise en oeuvre ou on règle ou adapte le fonctionnement des moyens d'infrastructure énergivores, des équipements fonctionnels énergivores et des moyens de conditionnement d'air énergivores, de sorte à pouvoir optimiser la performance énergétique du centre de traitement de données.

Selon les réalisations, on mesure la consommation électrique de la pluralité d'alimentations électriques et on mesure les paramètres reflétant les conditions de l'air impactant le conditionnement de l'air, d'un même temps donné, de façon continue ou de façon discontinue dans le temps.

Selon un développement, le procédé est mis en oeuvre pour une pluralité de centres de traitement de données distants. Dans ce cas, lorsque l'on souhaite optimiser la performance énergétique de l'un ou de plusieurs centres de traitement de données de la pluralité de centres de traitement de données, grâce aux moyens de traitement, on compare les indices et/ou indicateurs mesurés entre eux de plusieurs centres de traitement de données.

Selon une réalisation, on transmet les mesures de la consommation électrique de la pluralité d'alimentations électriques et les mesures des paramètres reflétant les conditions de l'air impactant le conditionnement de l'air des temps successifs à des moyens de stockage locaux.

Selon une réalisation, on transmet les mesures de la consommation électrique de la pluralité d'alimentations électriques et les mesures des paramètres reflétant les conditions de l'air impactant le conditionnement de l'air des temps successifs à des moyens de stockage distants du centre de traitement de données, avec, associés, les paramètres sur les caractéristiques des centres de traitement de données et de leurs moyens constitutifs.

Selon un second aspect, l'invention a pour objet une architecture d'un dispositif d'optimisation de la performance énergétique d'un centre de traitement de données, pour la mise en oeuvre du procédé qui vient d'être décrit, comportant :
- le centre de traitement de données, caractérisé par une pluralité de paramètres sur ses caractéristiques et ses moyens constitutifs, incluant :
   o au moins une salle, et des moyens d'alimentation électrique,
   o des moyens d'infrastructure énergivores tels que des moyens d'éclairage, associés à la au moins une salle et alimentés par les moyens d'alimentation électrique,
   o des équipements fonctionnels énergivores tels que des équipements électroniques, informatiques ou de télécommunications installés dans la au moins une salle et alimentés par les moyens d'alimentation électrique,
   o des moyens de conditionnement d'air associés aux équipements fonctionnels énergivores, des moyens de conditionnement d'air énergivores étant alimentés par les moyens d'alimentation électrique,
   o des moyens de mesure de paramètres reflétant les conditions de l'air impactant le conditionnement de l'air,
- des moyens de transmission de données, des moyens de stockage de données et des moyens de traitement de données,
- une pluralité de compteurs électriques,
- une pluralité de groupes homogènes relatifs à l'alimentation électrique et une organisation des moyens d'alimentation électrique de sorte à avoir une pluralité d'alimentations électriques séparées de la même pluralité de groupes homogènes relatifs à l'alimentation électrique, et à chaque alimentation électrique un compteur électrique associé, de sorte à pouvoir mesurer la consommation électrique de l'alimentation électrique correspondante.

Selon une réalisation, l'architecture comporte une pluralité de centres de traitement de données distants.

Selon une réalisation, l'architecture comporte des moyens de stockage locaux.

Selon une réalisation, l'architecture comporte des moyens de stockage distants du centre de traitement de données.

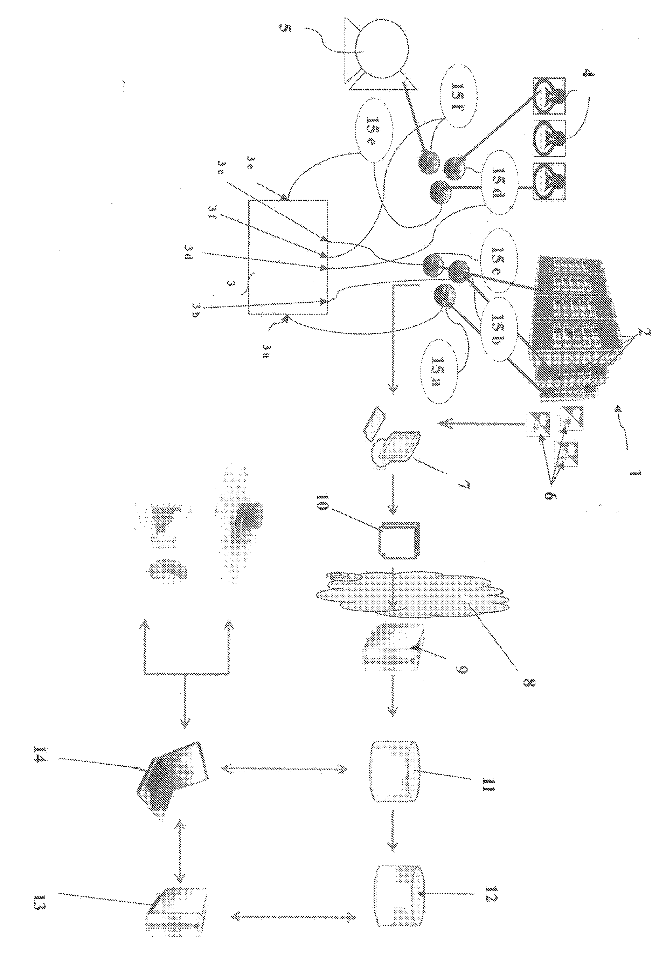

On décrit maintenant plusieurs modes de réalisation de l'invention à l'aide du dessin, dans lequel la figure 1, unique, est une vue schématique illustrant le procédé et l'architecture selon l'invention.

L'invention concerne un centre 1 comportant des équipements fonctionnels 2 énergivores, tels que des équipements électroniques, informatiques ou de télécommunications alimentés électriquement à partir d'une alimentation électrique 3. Un tel centre est par exemple un centre de traitement de données, mais l'invention s'applique à tout autre type de centre comportant des équipements fonctionnels 2 énergivores.

Un tel centre 1 comporte une ou plusieurs salles telles que des salles informatiques, chacune délimitant un espace interne dans lequel sont disposés, reposant sur un plancher ou un faux-plancher, plusieurs rangées de baies sur lesquelles sont installés les équipements fonctionnels 2, le plus souvent en nombre.

Par exemple, dans le cas d'un centre 1 de traitement de données, ces équipements fonctionnels 2 sont des équipements électroniques, informatiques ou de télécommunications.

Une rangée de baies et d'équipements fonctionnels 2 présente typiquement d'un côté une face avant et du côté opposé, une face arrière, pourvues de passages d'entrée d'air et de passages de sortie d'air.

Le centre 1 comporte des moyens d'infrastructure 4 énergivores tels que des moyens d'éclairage, associés aux salles et alimentés par l'alimentation électrique 3. Cette liste n'est qu'indicative et nullement exhaustive.

Le centre 1 comporte également des moyens de conditionnement d'air 5, associés aux équipements fonctionnels 2.

Certains au moins de ces moyens de conditionnement d'air 5 sont énergivores et alimentés par l'alimentation électrique 3.

Typiquement, les moyens de conditionnement d'air 5 sont associés, au moins, aux passages d'entrée et aux passages de sortie des baies et équipements fonctionnels 2. Il peut s'agir par exemple de moyens de refroidissement par ventilation de type dynamique, tels que ventilateurs intégrés aux baies, aux équipements 2 ou de type statique, tels que des passages profilés formant venturi.

De plus, ces moyens de conditionnement d'air 5 sont agencés pour introduire dans les salles informatiques de l'air provenant de l'extérieur du centre 1, aux fins de régénération.

Ces moyens de conditionnement d'air 5 sont choisis, calculés, agencés, commandés et réglés de manière à procurer aux faces avant et aux passages d'entrée d'air des équipements fonctionnels 2 de l'air filtré dont le débit, la température et le degré hygrométrique sont maintenus ou compris dans les plages de débits, de températures et de degrés hygrométriques adaptées au fonctionnement optimal des équipements fonctionnels 2.

En effet, il est établi que le conditionnement de l'air ambiant des équipements fonctionnels 2 des centres de traitement de données est un facteur clé déterminant pour le fonctionnement optimal de ces équipements 2 et donc du centre 1 lui-même.

Pour permettre le réglage des moyens de conditionnement d'air 5, il est prévu que le centre 1 comporte des moyens 6 de mesure des paramètres reflétant les conditions de l'air impactant le conditionnement de l'air. Ces moyens 6 de mesure sont destinés tant à l'air se trouvant dans les salles informatiques (le cas échéant dans des localisations spécifiques telles que les passages d'entrée d'air) qu'à l'air provenant de l'extérieur du centre 1, aux fins de régénération. Les paramètres mesurés sont typiquement la température, le degré hygrométrique, le débit, la vitesse, le vent, l'ensoleillement...

Bien entendu, on dispose d'une pluralité de paramètres sur les caractéristiques du centre 1 et de ses moyens constitutifs (équipements fonctionnels 2, d'infrastructure 4 et de conditionnement d'air 5). Ces paramètres permettent de constituer autant de références obtenues par traitement de données, relatives aux performances énergétiques de référence du centre 1.

L'invention vise à optimiser la performance énergétique du centre 1, ce qui inclut son contrôle. En effet, la consommation énergétique électrique des centres de traitement de données est importante et contribue de façon très significative au coût de fonctionnement de tels centres.

Pour ce faire, l'invention propose un procédé d'optimisation de la performance énergétique du centre 1 et une architecture de dispositif adaptée pour la mise en oeuvre de ce procédé.

Le procédé met en oeuvre et l'architecture comporte des moyens de transmission de données, des moyens de stockage de données et des moyens de traitement de données.

Par exemple, il est prévu une centrale d'acquisition de données 7 se trouvant sur le site même du centre 1, qui peut être associée, via le réseau de l'internet 8, à un serveur 9 d'un centre de traitement de données distant du centre 1.

Ainsi, la centrale d'acquisition de données 7 permet de générer des journaux de données représentés symboliquement en 10 qui peuvent être exportés vers le serveur 9 distant.

Au serveur 9 est associée une base de données de stockage 11 des données permettant de sauvegarder ces données.

Le serveur 9 permet de réaliser des traitements de données comme il sera exposé par la suite. Les données, indices et indicateurs en résultant sont importés dans une base de données de rapport 12.

Un serveur 13 associé à la base de données de rapport 12 permet la génération des rapports résultant des données, indices et indicateurs précédemment obtenus.

Une interface Internet 14 associée à la base de données de stockage 11 et à la base de données de rapport 12 permet l'édition et la consultation des rapports, le suivi des indices et indicateurs reflétant la performance énergétique du centre 1 et, après observation et analyse, la détermination de mesures propres à optimiser la performance énergétique.

Le cas échéant, les moyens de traitement sont aptes à permettre de faire des simulations de performance énergétique en fonction d'hypothèses sur les données, indices et indicateurs.

Bien entendu, les moyens de transmission de données, de stockage de données et de traitement de données sont aptes à permettre de comparer des données, indices et indicateurs correspondant à des temps de saisie différents, en vue d'une approche dynamique et non pas exclusivement statique.

Le procédé et l'architecture qui viennent d'être décrits peuvent être étendus d'un centre 1 unique à une pluralité de centres 1.

Dans ce cas, lorsque l'on souhaite optimiser (en particulier contrôler) la performance énergétique de l'un ou de plusieurs des centres 1 de la pluralité de centres 1, on compare les données, indices et indicateurs de plusieurs centres 1 entre eux.

Le procédé selon l'invention suppose d'avoir à disposition une pluralité de compteurs électriques 15a, 15b... et l'architecture pour la mise en oeuvre du procédé comprend la pluralité de compteurs électriques 15a, 15b...

D'autre part, on définit une pluralité de groupes homogènes relatifs à l'alimentation électrique et on organise les moyens d'alimentation électrique, à partir de l'alimentation électrique 3, de sorte à disposer d'une pluralité d'alimentations électriques séparées 3a, 3b... de la même pluralité de groupes homogènes relatifs à l'alimentation électrique.

On associe à chaque alimentation électrique 3a, 3b... un compteur électrique 15a, 15b...

Ainsi, on peut mesurer la consommation électrique de l'alimentation électrique de chaque groupe homogène énergivore et ce pour la totalité de la consommation électrique.

Cette segmentation de la consommation électrique totale peut être faite avec une approche matricielle et consolidation.

D'un côté, chaque centre 1 s'il y en a plusieurs. Pour chaque centre, chaque salle informatique ou groupe de salles.

D'un autre côté, consommation électrique des équipements fonctionnels 2, consommation électrique des moyens d'infrastructure 4, consommation électrique des moyens de conditionnement d'air 5.

La finesse de la segmentation peut être très élevée, à condition de disposer et de mettre en place un nombre correspondant de compteurs électriques 15a, 15b...

Grâce à cette architecture, il est possible de mesurer la consommation électrique dans le temps de la pluralité d'alimentations électriques 3a, 3b...

D'autre part, grâce aux moyens 6 de mesure des paramètres reflétant les conditions de l'air impactant le conditionnement de l'air, on mesure les paramètres reflétant les conditions de l'air impactant le conditionnement de l'air, d'un même temps donné. Ces mesures peuvent être réitérées pour des temps successifs.

Puis, grâce aux moyens de transmission de données, on transmet les mesures de la consommation électrique de la pluralité d'alimentations électriques 3a, 3b... et les mesures des paramètres reflétant les conditions de l'air impactant le conditionnement de l'air des temps successifs aux moyens de stockage 11 et on stocke ces mesures dans les moyens de stockage 11, avec les paramètres sur les caractéristiques du centre 1 et de ses moyens constitutifs associés aux mesures.

Lorsque l'on souhaite optimiser (ce qui inclut de contrôler) la performance énergétique du centre 1, grâce aux moyens de traitement 9, 13, on traite les mesures et les paramètres stockés dans les moyens de stockage 11 selon un ou plusieurs protocoles permettant de calculer des indices et/ou indicateurs quantitatifs et/ou qualitatifs stockés dans les moyens de stockage 12.

On peut alors comparer les indices et/ou indicateurs calculés avec des indices et/ou indicateurs de référence.

Puis, en fonction des écarts entre les indices et/ou indicateurs calculés et les indices et/ou indicateurs de référence, on adapte la mise en oeuvre ou on règle ou adapte le fonctionnement des moyens d'infrastructure 4, des équipements fonctionnels 2 et des moyens de conditionnement d'air 5.

C'est ainsi que l'on peut optimiser la performance énergétique du centre de traitement de données 1.

Selon les réalisations, on mesure la consommation électrique de la pluralité d'alimentations électriques et on mesure les paramètres reflétant les conditions de l'air impactant le conditionnement de l'air, d'un même temps donné, de façon continue ou de façon discontinue dans le temps.

Comme il résulte de la description qui précède, on transmet les mesures de la consommation électrique de la pluralité d'alimentations électriques et les mesures des paramètres reflétant les conditions de l'air impactant le conditionnement de l'air des temps successifs à des moyens de stockage locaux 7, alors qu'on transmet les mesures de la consommation électrique de la pluralité d'alimentations électriques et les mesures des paramètres reflétant les conditions de l'air impactant le conditionnement de l'air des temps successifs à des moyens de stockage 11, distants du centre 1. Bien entendu, sont associés aux mesures les paramètres sur les caractéristiques du centre 1 et de ses moyens constitutifs.

A titre indicatif, on donne ci-après une liste d'indices et d'indicateurs pouvant être calculés.

### Indices de performance :

€_UE : Indice économique global du centre (ratio entre le entre le coût énergétique total d'un centre et le coût propre à la consommation des équipements informatiques qu'il héberge), qui prend en compte la variation des tarifs de l'électricité dans le temps.
IE_EG : Indice énergétique du réseau d'eau glacée (ratio entre la consommation électrique du réseau d'eau glacée et la consommation ondulée des équipements informatiques)
IE_PF : Indice énergétique de la production de froid (ratio entre la consommation électrique des équipements pour la production de froid et la consommation ondulée des équipements informatiques)
IE_RC : Indice énergétique du réseau de condensation (ratio entre la consommation électrique des équipements du réseau de condensation et la consommation ondulée des équipements informatiques)
IE_AR : Indice énergétique aéraulique (ratio entre la consommation électrique des équipements de traitement de l'air et la consommation ondulée des équipements informatiques)

### Indicateurs de performance :

ID_PSV : Indicateur de puissance volumique (ratio entre le volume horaire d'air brassé par les climatiseurs et centrales de traitement de l'air et le volume des locaux)
ID_PSV : Indicateur de renouvellement d'air (ratio entre le volume d'air renouvelé d'une salle informatique et la charge ondulée des équipements informatiques de cette salle)
ID_DEG : Indicateur de dimensionnement du réseau d'eau glacée (ratio entre le volume d'eau glacée utilisé et la puissance ondulée utilisée des équipements informatiques)
ID_PDC : Indicateur de perte de charge (dans une salle informatique, ratio entre la pression au niveau du sous-plancher et la pression en reprise des armoires de climatisation)
ID_DDT : Indicateur différentiel de température (différence entre la température moyenne de soufflage d'air dans une salle et la température moyenne de reprise)
ID_VAF : Indicateur de volume d'air froid

### Indicateurs d'occupation :

Nombre d'U installés au m² (cet indicateur renseignant sur la capacité du centre informatique), U étant l'unité de hauteur connue de l'homme du métier des centres de traitement de données
Nombre d'U utilisés au m² (ce qui renseigne sur l'occupation du centre informatique)
Puissance moyenne installée / U (puissance informatique ramenée à 1 U).
Bien entendu, d'autres indices ou indicateurs peuvent être envisagés.

## Revendications

1. Procédé d'optimisation de la performance énergétique d'un centre de traitement de données (1), dans lequel :
- on dispose d'un centre de traitement de données (1) incluant :
o au moins une salle, et des moyens d'alimentation électrique (3),
o des moyens d'infrastructure (4) énergivores tels que des moyens d'éclairage, associés à la au moins une salle et alimentés par les moyens d'alimentation électrique (3),
o des équipements fonctionnels (2) énergivores tels que des équipements électroniques, informatiques ou de télécommunications installés dans la au moins une salle et alimentés par les moyens d'alimentation électrique (3),
o des moyens de conditionnement d'air (5) associés aux équipements fonctionnels (2) énergivores, des moyens de conditionnement d'air énergivores étant alimentés par les moyens d'alimentation électrique (3),
o des moyens de mesure (6) de paramètres reflétant les conditions de l'air impactant le conditionnement de l'air,
- on dispose d'une pluralité de paramètres sur les caractéristiques du centre de traitement de données (1) et de ses moyens constitutifs,
- on dispose de moyens de transmission de données, de moyens de stockage de données et de moyens de traitement de données (7, 8, 9, 10, 11, 12, 13, 14),
- on dispose d'une pluralité de compteurs électriques (15a, 15b...),
- on définit une pluralité de groupes homogènes relatifs à l'alimentation électrique et on organise les moyens d'alimentation électrique (3) de sorte à disposer d'une pluralité d'alimentations électriques (3a, 3b...) séparées de la même pluralité de groupes homogènes relatifs à l'alimentation électrique, et on associe à chaque alimentation électrique (3a, 3b...) un compteur électrique (15a, 15b...) de sorte à pouvoir mesurer la consommation électrique de l'alimentation électrique correspondante,
- puis, on mesure la consommation électrique de la pluralité d'alimentations électriques (3a, 3b...) et on mesure les paramètres reflétant les conditions de l'air impactant le conditionnement de l'air, d'un même temps donné, et on réitère ces mesures pour des temps successifs,
- puis, grâce aux moyens de transmission de données (7, 8, 9), on transmet les mesures de la consommation électrique de la pluralité d'alimentations électriques et les mesures des paramètres reflétant les conditions de l'air impactant le conditionnement de l'air des temps successifs à des moyens de stockage (11) et on stocke ces mesures dans les moyens de stockage (11), avec les paramètres sur les caractéristiques du centre de traitement de données et de ses moyens constitutifs associés aux mesures,
**caractérisé par le fait que** lorsque l'on souhaite optimiser la performance énergétique du centre de traitement de données (1), grâce aux moyens de traitement (9, 13), on traite les mesures et les paramètres stockés dans les moyens de stockage (11) selon un ou plusieurs protocoles permettant de calculer des indices et/ou indicateurs quantitatifs et/ou qualitatifs et on compare ces indices et/ou indicateurs avec des indices et/ou indicateurs de référence et, en fonction des écarts entre les indices et/ou indicateurs calculés et les indices et/ou indicateurs de référence, on adapte la mise en oeuvre ou on règle ou adapte le fonctionnement des moyens d'infrastructure (4) énergivores, des équipements fonctionnels (2) énergivores et des moyens de conditionnement d'air (5) énergivores, de sorte à pouvoir optimiser la performance énergétique du centre de traitement de données (1).

2. Procédé selon la revendication 1, dans lequel on mesure la consommation électrique de la pluralité d'alimentations électriques (3a, 3b...) et on mesure les paramètres reflétant les conditions de l'air impactant le conditionnement de l'air, d'un même temps donné, de façon continue dans le temps.

3. Procédé selon la revendication 1, dans lequel on mesure la consommation électrique de la pluralité d'alimentations électriques (3a, 3b...) et on mesure les paramètres reflétant les conditions de l'air impactant le conditionnement de l'air, d'un même temps donné, de façon discontinue dans le temps.

4. Procédé selon l'une quelconque des revendications 1 à 3, **caractérisé par le fait qu'**il est mis en oeuvre pour une pluralité de centres de traitement de données distants (1).

5. Procédé selon la revendication 4, dans lequel, lorsque l'on souhaite optimiser la performance énergétique de l'un ou de plusieurs centres de traitement de données (1) de la pluralité de centres de traitement de données, grâce aux moyens de traitement, on compare les indices et/ou indicateurs mesurés entre eux de plusieurs centres de traitement de données (1).

6. Procédé selon l'une quelconque des revendications 1 à 5, dans lequel on transmet les mesures de la consommation électrique de la pluralité d'alimentations électriques (3a, 3b...) et les mesures des paramètres reflétant les conditions de l'air impactant le conditionnement de l'air des temps successifs à des moyens de stockage locaux.

7. Procédé selon l'une quelconque des revendications 1 à 6, dans lequel on transmet les mesures de la consommation électrique de la pluralité d'alimentations électriques et les mesures des paramètres reflétant les conditions de l'air impactant le conditionnement de l'air des temps successifs à des moyens de stockage (11) distants du centre de traitement de données (1), avec, associés, les paramètres sur les caractéristiques des centres de traitement de données et de leurs moyens constitutifs.

8. Architecture d'un dispositif d'optimisation de la performance énergétique d'un centre de traitement de données (1) pour la mise en oeuvre du procédé selon l'une quelconque des revendications 1 à 7, comportant :
- le centre de traitement de données (1), **caractérisé par** une pluralité de paramètres sur ses caractéristiques et ses moyens constitutifs, incluant :
o au moins une salle, et des moyens d'alimentation électrique (3),
o des moyens d'infrastructure (4) énergivores tels que des moyens d'éclairage, associés à la au moins une salle et alimentés par les moyens d'alimentation électrique (3),
o des équipements fonctionnels (2) énergivores tels que des équipements électroniques, informatiques ou de télécommunications installés dans la au moins une salle et alimentés par les moyens d'alimentation électrique (3),
o des moyens de conditionnement d'air (5) associés aux équipements fonctionnels (2) énergivores, des moyens de conditionnement d'air énergivores étant alimentés par les moyens d'alimentation électrique (3),
o des moyens de mesure (6) de paramètres reflétant les conditions de l'air impactant le conditionnement de l'air,
- des moyens de transmission de données, des moyens de stockage de données et des moyens de traitement de données (7, 8, 9, 10, 11, 12, 13, 14),
- une pluralité de compteurs électriques (15a, 15b...),
- une pluralité de groupes homogènes relatifs à l'alimentation électrique et une organisation des moyens d'alimentation électrique de sorte à avoir une pluralité d'alimentations électriques séparées (3a, 3b...) de la même pluralité de groupes homogènes relatifs à l'alimentation électrique, et à chaque alimentation électrique (3a, 3b...) un compteur électrique associé (15a, 15b...), de sorte à pouvoir mesurer la consommation électrique de l'alimentation électrique correspondante.

9. Architecture selon la revendication 8 comportant une pluralité de centres de traitement de données (1) distants.

10. Architecture selon l'une quelconque des revendications 8 et 9, qui comporte des moyens de stockage locaux.

11. Architecture selon l'une quelconque des revendications 8 à 10, qui comporte des moyens de stockage (11) distants du centre de traitement de données (1).
